# EUROPEAN PATENT APPLICATION

(11) **EP 2 180 273 A2**
(43) Date of publication of application: **28.04.2010**
(21) Application number: 09013430.5
(22) Date of filing: 23.10.2009
(51) Int. Cl.: F24J 2/38, F24J 2/46, F24J 2/54, H01L 31/042

(54) **Solar tracking for terrestrial solar arrays**

(30) Priority: 24.10.2008 US 258253
(71) Applicant: Emcore Corporation, Somerset, NJ 08873 (US)
(72) Inventor: Sherman, James, Hillsborough, New Jersey 08844 (US)
(74) Representative: Wagner, Karl H.

(57) **Abstract**

An automated method causes a terrestrial solar cell array (105) to track the sun. The solar cell system includes drive motors (210,211) that adjust a position of the array relative to respective different axes. The position of the sun is predicted at a future time, and a kinematic model for the solar cell array is used to determine respective positions for the motors corresponding to aligning the solar cell array with the sun at that future time. The future time may correspond to any time during solar tracking operation, which may begin at sunrise or after sunrise. Additionally, an alignment analysis may be performed during solar tracking to properly align the solar cell array with the sun. The technique may sweep one or more solar cells along determined paths (e.g., azimuth and elevation paths) while measuring an output parameter indicative of system performance. The measured data is analyzed to determine if the solar cell system is in misalignment in which case the solar cell system is moved into proper alignment. The alignment procedure may be implemented on a periodic basis or using triggers, and maybe automatically executed or manually executed.

## Description

### TECHNICAL FIELD

This disclosure relates to solar tracking for terrestrial solar cell arrays.

### BACKGROUND

This disclosure relates generally to solar tracking for use with one or more terrestrial solar cell arrays that convert sunlight into electrical energy. Accurate solar tracking is necessary because the amount of power generated by a given solar cell is related to the amount of sunlight that impinges on it. In an array, therefore, it is advantageous to optimize the amount of sunlight that impinges on each constituent solar cell. Optimization may be achieved by continually orientating the array relative to the sun using motors and actuators to move the array along a predetermined path based on a developed solar tracking model. These models for movement of the solar panel are designed to track actual sun movement and thus vary depending on the day and time and vary across the year.

Such solar tracking is hindered, however, when external conditions cause the model to no longer align with the actual path of the sun. External conditions include slowly-varying events such as when a solar panel begins to sag or bend during operation resulting in misalignment. This sagging and bending, for example, can occur more frequently during the summer months when the array is in a more horizontal, higher elevation position. Other external conditions include shifts in the foundation or ground beneath a solar panel, as well as sudden changes in positions resulting from wind gusts and the like.

These external conditions can result in a determined model for solar panel tracking that is not aligned, or not optimized, with the actual path of the sun. These external conditions can affect different types of solar panels (individual solar panels, single support solar panel arrays, longitudinally-supported solar panel arrays, etc.).

### SUMMARY

An object of the invention is to track the movement of the sun using a solar power system that moves according to a determined model based on a predicted position of the sun at a future time. In some examples, that position is based on expected azimuth and elevation positions of the sun at a future time after sunrise and before sunset. The solar power system may be a solar array such as comprising a solar panel, subarray, section, and/or module.

An object of the invention is to measure the alignment of a solar array with the actual position of the sun during movement of the solar array for solar tracking.

An object of the invention is to adjust the position of the solar array into an aligned position with the sun during solar tracking, by moving the solar array to different positions to determine an optimum position of the solar array.

An object of the invention is to activate at least one drive means to move the solar array for solar tracking.

An object of the invention is to activate at least one drive means to move the solar array for aligning the solar array with the sun.

An object of the invention is to control movement of the solar array using two drive means, one controlling movement of the solar array along a first directional path, the other controlling movement of the solar array along a second directional path.

An object of the invention is to activate drive means to move the solar array into the aligned position in response to a measured characteristic of the solar array.

An object of the invention is to determine if the actual path of the sun is aligned with a predictive model of sun movement during solar tracking.

An object of the invention is to adjust the movement of the solar array, if the actual path of the sun is not aligned with the movement of the solar array based on the current model.

An object of the invention is to optimize a current model used to move the solar array, if the actual path of the sun is not aligned with the movement solar array based on the current model.

Various other aspects of the invention are set forth in the claims.

### BRIEF DESCRIPTION OF DRAWINGS

FIG. 1A, 1B, 1C and 1D are an illustration of a solar cell array tracking the sun during different times of the day.

FIG. 2 illustrates further details of an example of a solar cell array.

FIG. 3 is a block diagram of an implementation of a terrestrial solar tracking system.

FIG. 4 is a flow chart of a terrestrial solar tracking technique.

FIG. 5 is a flow chart of a terrestrial solar tracking similar to that of FIG. 4, but adapted for variable start and stop positions.

FIG. 6 is a block diagram illustrating solar tracking as a function of time.

FIG. 7 is a plot of elevation versus time for a solar cell array in accordance with an example implementation of the techniques of FIG 4.

FIG. 8 is a block diagram of an implementation of a kinematic model for a terrestrial solar cell array.

FIG. 9 sis a block diagram of an implementation of an alignment algorithm routine.

FIGS. 10A, 10B and 10C are an illustration of a solar cell array in a first neutral position, a first offset position in a positive direction of an azimuthal sweep, and a second offset position in a negative direction of the azimuthal sweep.

FIGS. 11A, 11B and 11C are an illustration of a solar cell array in a second neutral position, a third offset position in a positive direction of an elevational sweep, and a fourth offset position in a negative direction of the elevational sweep.

FIG. 12 is block diagram of an implementation of kinematic model for performing an alignment algorithm routine for a terrestrial solar cell array.

### DETAILED DESCRIPTION

A terrestrial solar power system converts sunlight into electrical energy utilizing, e.g., multiple mounted solar cell arrays spaced in a grid or other pattern over the ground. The solar array may include subarrays, sections, modules and/or panels, mounted together for controlled movement or mounted independently.

The amount of power generated by the solar array is directly related to the amount of sunlight impinging upon the constituent solar cells. Therefore, desirably, the plane of the array (of lenses and solar cells) is oriented orthogonal to the incoming rays of the sun, and the power generation is maximized. Solar tracking mechanisms are employed that ensure that this plane (e.g., the concentrator lens) results in a beam projected on the center of the respective solar cells in a continuous manner as the sun traverses the sky during the day.

The solar tracking mechanism optimally predicts the location of the sun at a future time, and orients the array such that it aligns with the sun at that future time. Performing this process repeatedly yields the advantageous result that the array remains substantially aligned with the sun's rays. This approach involves not only predicting where the sun will be, but predicting how to operate one or more drive means (e.g., motors and/or actuators) to orient the solar array to meet the sun's rays at that future time. The solar tracking system employs a kinematic model that correlates movement of the one or more motors with the movement of the solar panel.

### Solar Tracking

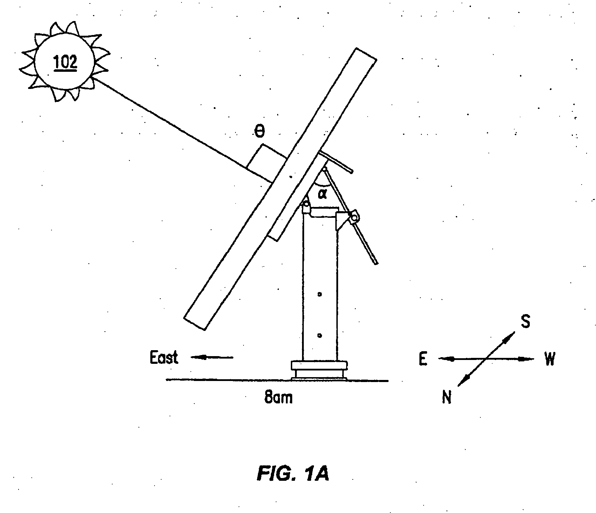

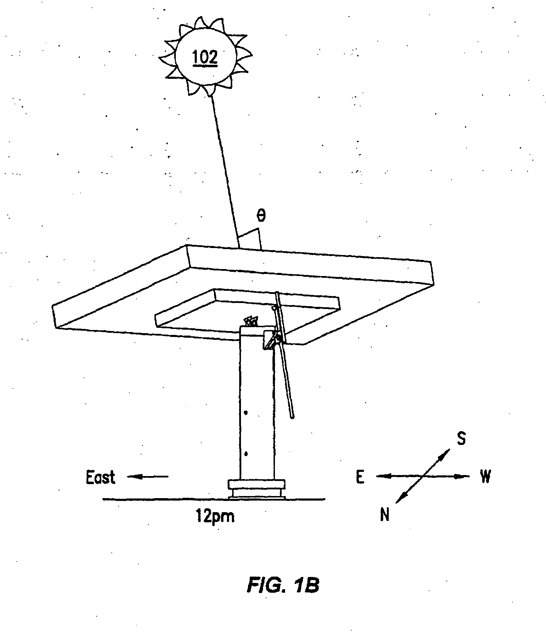

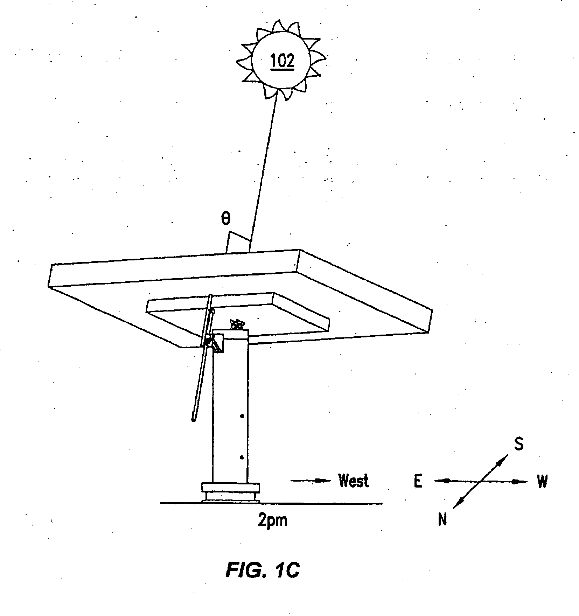

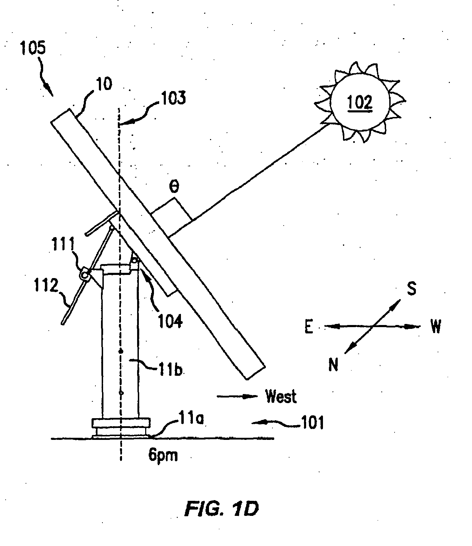

FIG. 1A, 1B, 1C and 1D are an illustration of a single-tower solar cell array system 105. Specifically, the solar cell array system 105 tracks the sun 102 during different times of the day. This solar cell array system 105 comprises a plurality of modules, each with many different solar cells, together forming a two dimensional solar cell array 10 and mounted through a single vertical mounting mechanism. The Figures are oriented on the page so that the north direction is out of the page, south is into the page, east is to the left of the page, and west is to the right of the page. The solar cell array system 105 is in a vertical support configuration with a central support (11 a, 11 b) that is fixed to a base 101, for example, a concrete foundation on a surface of the earth. The solar cell array system 105 includes a solar cell array 10 mounted to the central support (11 a, 11b) by way of a jackscrew 111, threaded rod 112 and pivot point (e.g., a hinge) 104. The solar cell array 10 includes a generally rectangular array of solar cell receivers (e.g., each receiver including a Fresnel lens and a triple junction III-V compound semiconductor solar cell).

The solar cell array 10 is kept orthogonal to the rays of the sun 102 as the sun 102 traverses across the sky, by rotating the solar cell array 10 about two substantially perpendicular axes (e.g., along azimuth and elevation direction) to account for the sun's elevation and azimuth. In other examples below, these axes may not be perpendicular. To adjust for the sun's azimuth, an azimuth drive means (motor 210) causes the solar cell array 10 to rotate about axis 103 (i.e., the longitudinal axis of the central support 11 a, 11b). To adjust for the sun's elevation, an elevation drive means (motor 211) causes the translation of the threaded rod 112 in the jackscrew 111. Because the solar cell array 10 is coupled to the central support (11 a, 11 b) by a hinge 104, translation of the threaded rod 112 adjusts the angle of the solar cell array 10 (i.e., the solar cell array 10 rotates about the hinge 104). The angle "α" (alpha) shown in FIG. 1A is the "jack angle" which is used by the software in an embodiment of the present invention.

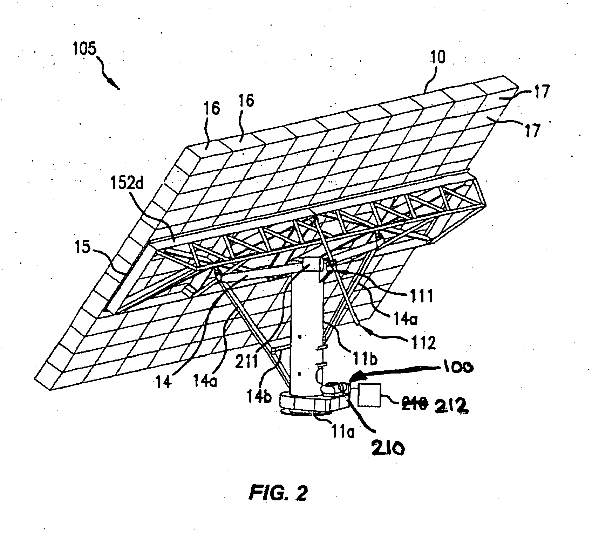

FIG. 2 illustrates a terrestrial solar cell array system 105 in greater detail. The solar cell array system 105 of FIG. 2 is described in co-owned U.S. Patent Application Serial No. 12/131,556, filed June 2, 2008. In general terms, the solar cell array system 105 comprises three major components. The first major component is the central support (11 a and 11 b). The central support is mounted to a surface (e.g., item 101 of FIG. 1A) and is capable of rotating about its longitudinal axis. Depending on the implementation, the surface can be, e.g., the ground or a concrete foundation formed in the ground. Disposed on or adjacent to the surface is a drive mechanism 100 (e.g., azimuth motor 210 of FIG. 2) that couples to the central support. The drive mechanism 100 enables the inner member 11b to rotate relative to the outer member 11a, e.g., for moving the solar cell array 10 such that it tracks the azimuth of the sun. The drive mechanism can include motor 210 along with one or more gears. In the illustrated example, a controller 212 controls operation of the drive means 210 and 211, for example, by_ executing a software algorithm to determine respective actuation of the drive means according to a determined model for solar tracking.

The second major component is the support frame 15. The support frame 15 couples to the central support and is adapted to support the solar cell array 10. The third major component is the solar cell array 10. The solar cell array 10 includes multiple subarrays 16 and is coupled to, and supported by, the support frame 15. Each solar cell subarray 16 is divided into thirteen sections 17, each including a 2 x 7 array of concentrating lenses each disposed over a respective single receiver. The receiver, a printed circuit or subassembly, includes a single III-V compound semiconductor solar cell together with additional circuitry such as a bypass diode (not shown). In some implementations, each section 17 is a module, e.g., a discrete assembly.

The central support includes an outer member 11a and an inner member 11 b. The outer member 11a is connectable to a support mounted on the surface by bolts. The inner member 11b is rotatably mounted within the member 11 a and supports a cross member 14 which is connected to a support frame 15. The support frame 15 also is supported on the inner member 11b by a pair of inclined arms 14a which extend respectively from the support frame 15 to the base of the inner member 11 b. The inclined arms 14a are coupled to each other by a cross-member 14b that increases their structural integrity. The mounting of the support frame 15 in this manner ensures that it is fixed to the inner member 11 b of the central support in such a manner that it is rotatable about its central longitudinal axis through members 11a and 11b.

Jackscrew 111 and mating threaded rod 112 together can adjust the angle of the panel 10 to track the elevation of the sun. Thus, the jackscrew 111 in combination with a drive mechanism 111 a (e.g., elevation motor 211 of FIG. 2) enables pivoting the support frame 15 about hinge 104, and thus the solar cell array 10, so as to adjust its angle with respect to the earth's surface.

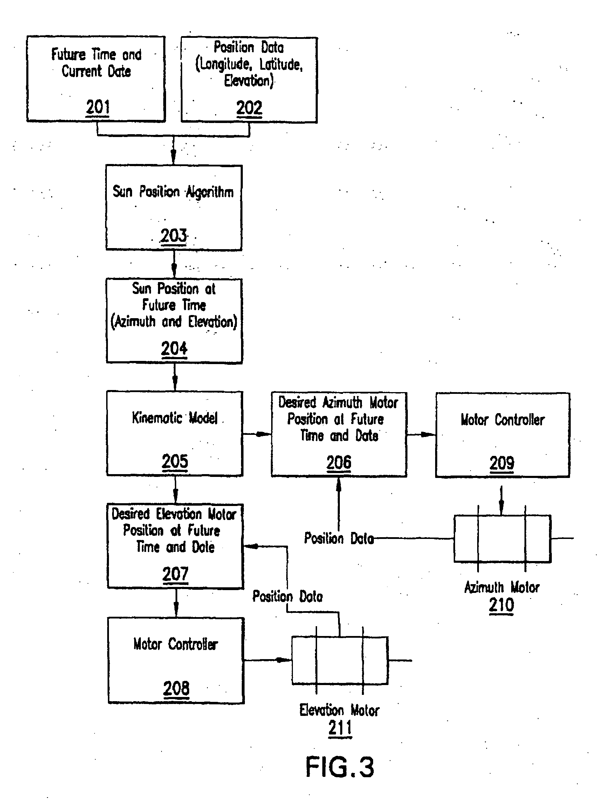

FIG. 3 is a block diagram of an implementation of a terrestrial solar tracking system for the panel 10, and as may be implemented by the controller 212. The system receives as input data (a) the date and a future time 201 and (b) position data of the array 202, including, e.g., longitude, latitude and elevation above sea level. Such data may be stored on a memory in the controller 212 or communicated to the controller from another location. In this implementation, the system utilizes a future time 201 rather than the current time so that rather than lagging behind the sun, the array can be oriented to align with the sun at its expected position at the future time. In some implementations, the future time 201 is one minute into the future. In some implementations, the future time 201 can be sunrise, so that upon sunrise, the solar cell array 10 is aligned with the sun at sunrise. In other implementations, the future time 201 is at sunrise or at some predetermined time after sunrise that serves as a start up time corresponding to when the solar cell array 10 will begin tracking the sun. This start up future time is when the solar cell array 10 is first oriented toward the sun for tracking during the day time. While a future time associated with actual sunrise may be used, using a start up time after sunrise allows the solar cell array 10 to start tracking the sun from a tilted start up position (e.g., the position of the solar panel in FIG. 1A), instead of from a fully (or nearly) vertical position facing the sunrise on the horizon. In some examples, the start up position corresponding to this start up time may be the same as the "parked" (or storage) position of the solar cell array 10 during a night mode. For example, a start up position may be a predetermined angular position of 15 degrees, instead of 0 degrees. In any event, to maintain alignment, the system can repeat its alignment calculation periodically (e.g., every minute) or continuously.

Based on at least the input data 201, 202, a sun position predictor in the form of a sun position algorithm 203 calculates the position of the sun (e.g., its azimuth and elevation) at that future time 204. In some implementations, the sun position algorithm 203 includes the Solar Position Algorithm (SPA) available from the National Renewable Energy Laboratory (see http://rredc.nrel.gov/solar/codesandalgorithms/spa/ and http://www.nrel.gov/docs/fy08osti/34302.pdf, both of which are incorporated herein by reference).

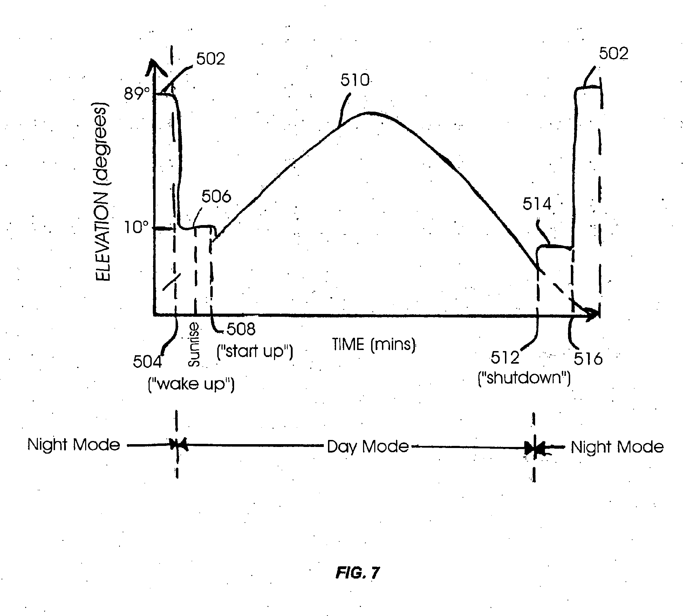

The sun's azimuth and elevation at the future time 204 are input data to a kinematic model 205. The kinematic model (see FIG. 7) correlates the sun position at the future time 204 with a corresponding movement of the azimuth motor 210 and the elevation motor 211 such that the solar cell array 10 is aligned with the sun at the future time 201. As such, the kinematic model 205 facilitates calculation of the appropriate actuation of the azimuth motor 206 and the elevation motor 207 so that the solar cell array 10 is aligned with the sun's elevation and azimuth at the future time 204. Each of the motors 210, 211 includes a position encoder that determines the current position of each respective motor (e.g., measured by the rotational position of the drive shaft, represented as an integral number of "counts" or increments of a predetermined numbers of degrees, starting from zero and continuing through 360 degrees for one turn, 720 degrees for two turns, etc.). For control purposes, the position data is fed back to the motor position calculation 206, 207. The position encoder may determine position based on a baseline position corresponding to a start up position of the solar panel. This start up position for solar tracking may be one in which the solar cell array 10 starts tracking the sun at sunrise. However, in other implementations, this start up position corresponds to a position at a future time after sunrise, at which the solar cell array 10 is to start tracking the sun.

The data of blocks 201-207 can be stored in one or more data stores (e.g., magnetic media, solid state media, or other suitable memory structure). The processing of, e.g., blocks 203 and 205-209 can be performed by, e.g., one or more microprocessors or special- or general- purpose computers.

### Example 1

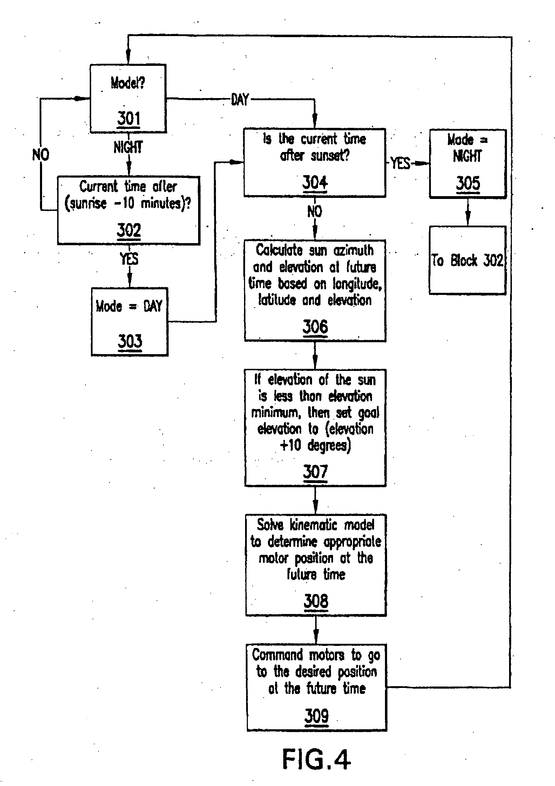

FIG. 4 is an example implementation of a method for terrestrial solar tracking to predict the position of the sun during the course of the day and determine actuations to cause the drive means to align the solar cell array with such predictions. The method may be implemented using the controller 212. First, the mode is determined at step 301. If it is Night mode, it is determined whether the current time is after 10 minutes before sunrise at step 302. If not, the mode remains night, and step 302 is repeated until a mode change occurs. Night mode, in some implementations, orients the solar cell array 10 in a manner that minimizes damage from weather or other hazards.

If the current time is after 10 minutes before sunrise, the mode is set to a Day mode at step 303. But if it is also determined that the current time is after sunset at step 304, the mode is set to night at step 305. If the current time is not after sunset, the sun's azimuth and elevation at the future time are calculated using the sun position algorithm at step 306. The future time can vary with the implementation, but in some implementations, the future time is one minute into the future.

The solar cell array 10 may be "parked" overnight in a position pointing away from the night sky or sun, to protect it from weather or other environmental conditions when it is not in use. The "start up" position is not necessarily pointing towards the horizon at sunrise, although it can be. A start up position may be set at, for example, 5, 10, or 15 degrees above the horizon. If mountains are on the horizon, the angle may even be greater. Preferably, some time after sunrise the tracking process may be initiated. The solar cell array 10 is moved from a rest position (which may, for example be 15 degrees above the horizon), to the position of the sun at a predetermined start time (i.e. a predetermined "future" time). The tracking process then follows the sun as it moves from the start position during the course of the day.

Using the sun's elevation and the azimuth, the kinematic model is used to determine the appropriate position of the azimuth and elevation motors (e.g., the rotational position of the drive shafts) to orient the solar cell array 10 such that it is aligned with the sun at the future time at step 308. The elevation and azimuth motors are then commanded to the appropriate positions at the future time at step 309. The step 309 may control the speed of the motors such that, at the future time, the solar cell array 10 is aligned with the sun's position at the future time, and do so in a smooth movement manner. Example implementation of the kinematic model is also discussed in FIG. 7 below.

### Example 2

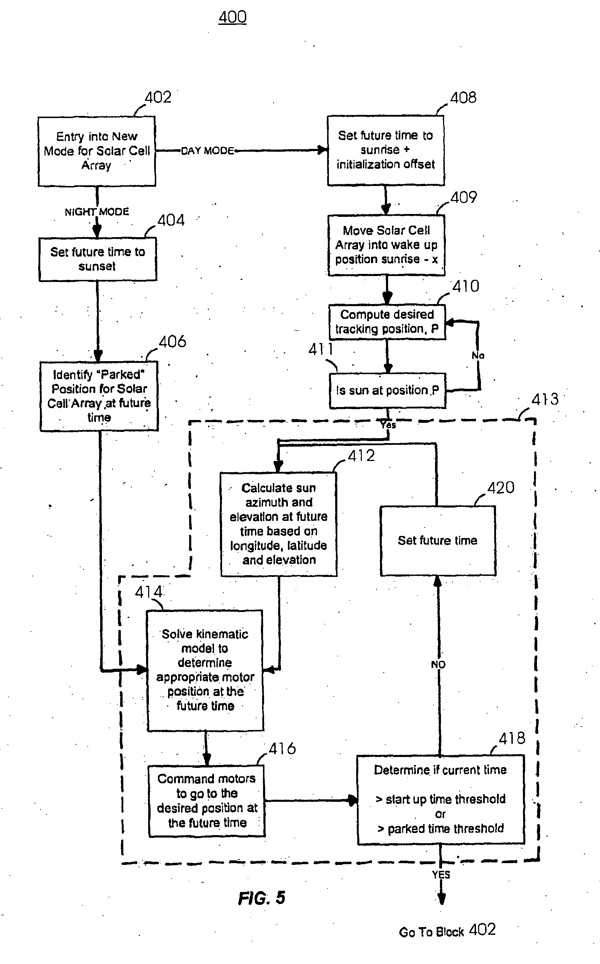

In another example to predict the position of the sun and determine actuations to cause the drive means to align the array with such predictions, the cell array 10 is controlled in a similar way to that of FIG. 4, but has a variably controlled start and stop time for solar tracking. This method may be implemented using the controller 212 and can begin tracking of the sun at a predetermined, but variable time after sunrise, and can stop solar tracking at a predetermined, but variable time before sunset. FIG. 5 illustrates an example method 400, in which step 402 determines whether the solar cell array system is entering into a one of either a Night mode, where the solar cell array 10 is not activated to collect solar energy, or a Day mode, where the solar cell array 10 is to track the sun and absorb solar energy.

Generally speaking, for both Examples 1 and 2, "Night mode" refers to a time frame over which the solar cell array 10 is no longer tracking the sun, but rather has been placed in a "parked" position, intermediate position, or otherwise to maintain the solar cell array 10 until a Day mode is reached. The "Night mode" may start before or after sunset, but generally coincides with the night time. The "Day mode" refers to a time frame over which the solar cell array 10 is tracking the sun or is put into a ready, or intermediate position, to begin tracking the sun. The "Day mode" may start before or after sunrise - preferably it starts at a predetermined time before - but generally coincides with the time from sunrise to sunset when the sun is positioned in the sky and available for tracking, irrespective of obstacles and weather conditions affecting such tracking.

The block 402 determines when the solar cell array system's mode is changing from the Day mode to the Night mode or from the Night mode to the Day mode. If the solar cell array system is moving from Day mode to Night mode, then a block 404 sets a future time to a time for entering the solar cell array into a "parked" position, e.g., sunset or some offset time before or after sunset. In the illustrated example, the step 404 specifically sets the future time to sunset.

A step 406 identifies the "parked" position corresponding to that future time, where the "parked" position is the position that the solar cell array will be kept in during the Night mode, such as pointing away from the night sky or sun. Alternatively, identifying the parked position as being one to store the solar cell array 10 for non-operation, the step 406 may determine that the appropriate "parked" position is one in which the solar cell array 10 is made to point in the expected direction of the next sunrise or the sun some time thereafter. In these and other embodiments, the parked position may be one in which the solar cell array 10 is maintained at an angled position that is neither fully vertical nor fully horizontal. By maintaining the solar cell array 10 at an angled, predetermined position, when the system 400 enters the Day mode, the solar cell array system 10 can quickly move to a "start up" position for tracking the sun, or to an intermediate "wake up" position where it is held prior to start up. Once the future time for parking the solar cell array system 10 has been identified by block 404, the system 400 is then able to identify either a position for dormancy during the Night mode, the next position at which the sun will be tracked during the Day mode, or some other position predetermined for storage of the solar cell array 10.

Returning to step 402, if it is determined that the solar cell array 10 is entering a Day mode from a Night mode, a step 408 sets the future time to some start up time that is sunrise plus some initialization offset time. The step 408 is described as operating in a Day mode; yet, this mode may be executed at any point after the solar cell array 10 has been parked for the Night mode. The step 408 will typically determine the future time to sunrise and the initialization offset during the night. The sunrise may be a projected sunrise based on calculated or provided data. The initialization offset time for example may be some predetermined time after sunrise that serves as a start up time at which the solar panel will begin tracking the sun:

At start up from the step 408, the future time may be sunrise plus 10 minutes, 20 minutes, or 40 minutes, for example. The particular future time for start up identified by the step 408 may be predetermined or it may be based on a desired sun azimuth and elevation, other than sunrise, at which the solar cell array 10 is to start tracking. For example, if the elevation of the sun is less than an elevation minimum for solar tracking, then the system may be designed to wait until the future time when the sun is at the desired azimuth and/or elevation. Using a start up time after sunrise allows the solar cell array 10 to start tracking the position of the sun from an angled, start up position as determined by the step 409 instead of from an initial vertical position. Any other future time values 420 may be measured as an amount of time that has or will have elapsed from the start up time (408).

With the future startup time set to some time after sunrise by step 408, the solar cell array 10 is activated at step 409, preferably at some time, x (minutes), before sunrise. This time corresponds to a time where the actuators, motors, etc. of the solar cell array system are powered up from a dormant (power save) state to a powered state. The value of x is arbitrary and may be set to a few minutes, for example 3 minutes, 0 minutes (i.e. sunrise) or otherwise. The step 409 may calculate or already have stored an identified "wake up" position for the solar cell array 10, and in step 409 the motors of the solar cell array system are actuated to position the solar cell array 10 into a "wake up" position. This typically means decreasing or increasing elevation compared to that of the "parked" position of the Night mode. The time x is set such that there is sufficient time to move the solar cell array 10 into the "wake up" position prior to solar tracking. The "wake up" position may be the "start up" at which point the solar cell array 10 is to begin solar tracking. However, preferably the "wake up" position is an intermediate position, shy of the "start up" position, but sufficiently close to the "start up" position to make movement into that position occur considerably faster than would occur if moving directly from the "parked" position to the "start up" position.

The "wake up" position is optional, but provides an intermediate position for faster "start up" of solar tracking, because of short travel distance to the solar tracking position. An intermediate position may be 3 degrees (elevation) above the highest calculated initial elevation (start up elevation) for solar tracking at any point during the year, i.e., 3 to 10 degrees above the highest computed elevation value for P for the year.

A desired position, P, of the sun at which tracking by the solar panel is to occur is computed at step 410. This calculation may be of the sun's azimuth and elevation positions at the time identified by the step 408, namely the projected sunrise time plus some initialization offset. As the sun rises and moves, a control loop is formed by steps 410 and 411 to determine when the sun is at the desired position, P, to start solar tracking. Once the desired position is reached, the sun is tracked by a tracking process generally illustrated in the example of FIG. 5 as step 413.

Step 410 may identify the "start up" position based on the start-up time from step 408. The exact position of the start up position may depend on the particulars of the neighboring geographic terrain, nearby man made obstructions, or for any other reason related to optimizing solar panel usage. While the steps 408, 409, 410 and 411 are shown separately, these steps may be combined together into the same algorithm.

Based on the start-up position, the sun's azimuth and elevation at the future time are calculated using the sun position algorithm at step 412, which may calculate the azimuth and elevation at any future time, not just the start up time. The future time can vary with the implementation, but in some implementations, the future time is one minute into the future, five minutes into the future, or some greater or less amount of time into the future.

For a Day mode, using the sun's elevation and the azimuth, the kinematic model is used to determine the appropriate position of the azimuth and elevation motors (e.g., the rotational position of the drive shafts) to orient the solar cell array such that it is aligned with the sun at the future time 414. In a Day mode, the kinematic model 414 starts by determining the appropriate motor positions for the start-up position identified in the step 409 and using the data from the step 412. After this initialization start-up, the kinematic model determines at step 414 the appropriate positions at for any future time, as part of the normal solar tracking procedure. With the data from the kinematic model, the elevation and azimuth motors are then commanded to the appropriate positions at the future time at step 416.

For a Night mode, the kinematic model is used to determine the appropriate position of the azimuth and elevation motors to orient the solar cell array to the "parked" position identified in step 406, and the elevation and azimuth motors are then commanded to the appropriate positions by the step 416.

After or during motor movement, step 418 tracks the current time to determine if the current time is in a region at which a change in mode occurs. For example, step 418 determines if the current time is greater than a start-up time threshold, such as after sunrise, sunrise + initialization offset time, or sunrise - some initial machine ramp up time. Or step 418 may determine if the current time is greater than a parked time threshold, such as after sunset, sunset + some time, or sunset - some time. If the current time is in one of these mode changing regions control is passed to the step 402, as a mode change as been confirmed. Otherwise, control is passed to step 420 which determines the next future time for Day mode solar tracking, and then instructs the block 412 to calculate the sun azimuth and elevation at the new future time.

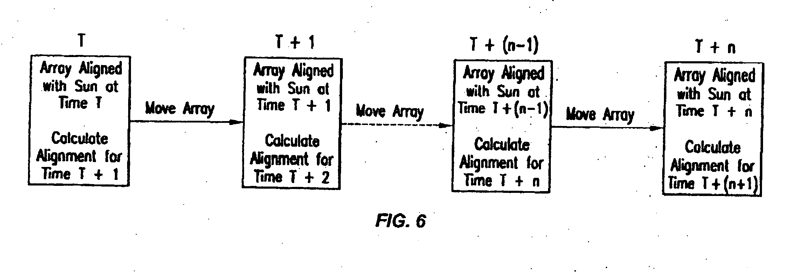

FIG. 6 illustrates an example of solar tracking as a function of time As described, the solar tracking system predicts the position of the sun at a future time (e.g., one minute into the future) and begins moving the solar cell array 10 so that when then future time arrives, the solar cell array 10 is aligned with the sun's future position. The calculating and moving can be done continuously (e.g., such that the sun's future position is continuously being calculated and the solar cell array is continuously moving) or can be done periodically or intermittently (e.g., every minute, the sun's future position is calculated and the solar cell array is moved).

Thus, at time T, the solar cell array 10 is aligned with the sun's position at time T. At the same time, the position of the sun at a future time T + 1, (e.g., one minute into the future) is calculated, as well as the manner of actuating the azimuth and elevation motors based on the kinematic model so that the solar cell array 10 aligns with the sun's position at time T + 1. Between T and T + 1, the solar cell array is moved such that at time T + 1, the solar cell array 10 is aligned with the sun's position at time T + 1. Likewise, at time T + 1, the position of the sun at a future time T + 2 is calculated, as well as the manner of actuating the azimuth and elevation motors based on the kinematic model so that the solar cell array 10 aligns with the sun's position at time T + 2. The process continues such that at T + n (i.e., an arbitrary time in the future), the solar cell array 10 is aligned with the sun at its position at time T + n, and the position of the sun at a future time T + (n +1) is calculated, as well as the manner of actuating the azimuth and elevation motors based on the kinematic model so that the solar cell array aligns with the sun's position at time T + (n + 1).

FIG. 7 illustrates a timing diagram 500 for the Example 2 (FIG. 4). At the leftmost side of the diagram, the solar cell array 10 is in a "parked" position 502 that was initiated from the Night mode occurring at the rightmost side of the diagram. In this example, the solar cell array 10 is stored at 89 degrees during the morning until a "wake up" time 504, at sunrise - x minutes, occurs. At "wake up," the solar cell array system powers fully up and the motors are controlled to move the solar cell array 10 to a "wake up" position 506, which in the illustrated example corresponds to about 10 degrees elevation (e.g., as identified by block 309). The "wave up" position is an intermediate position between the "parked" position 502 and the "start up" position. The exact "wake up" position may of course be different. The solar cell array 10 is held at this position until a start up time 508 has occurred, corresponding to the sunrise time plus initialization offset from block 308, at which point the solar cell array 1.0 moves from the. "wake up" position to the determined "start up" position, from which solar tracking occurs. The region 510 of the elevation plot shows the elevation of the solar cell array 10 during solar tracking. This region 510 may also correspond to the elevation path of the sun as it moves across the sky, i.e., when the solar array is properly tracking the sun. The elevation of the solar panel changes until dusk, in this example.

In the illustrated example, as the solar cell array 10 tracks the sun, the solar cell array 10 eventually approaches another intermediate time 512 corresponding to a "shut down" position 514 where the elevation of the solar cell array 10 is increased to a "shut down" elevation, which is below about 10 degrees in the illustrated example. The solar cell array 10 is maintained at this "shut down" position, until a "parked" position has been identified and the solar cell array is moved into that "parked" position for storage in the Night mode. Merely by way of example, in this example the Day mode extends from the "wake up" time 504 to the "shut down" time 512. In other examples, the Day mode may start or stop on other time events illustrated in FIG. 7, such as between "start up" time 508 and a night storage time 516.

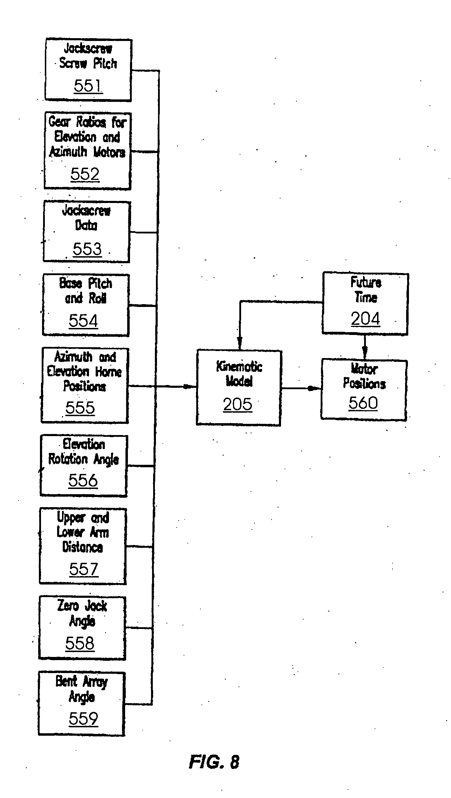

FIG. 8 illustrates an implementation that may be of any of kinematic model described above, which includes the kinematic model 205 (FIG. 3), the kinematic model 308 (FIG. 4), and the kinematic model 414 (FIG 5). For convenience sake, the following description is provided in reference to kinematic model 205. The kinematic model 205 correlates movement of the azimuth and elevation motors with the movement of the solar cell array 10. Therefore, if the desired position of the solar cell array 10 is known (e.g., vis-à-vis the position of the sun at a given time), the kinematic model 205 can derive how the motors should be actuated to move the solar cell array 10 to the desired position (e.g., move the azimuth motor driveshaft 0.5 degrees and move the elevation motor driveshaft 2 degrees).

To perform the correlation function, the kinematic model 205 receives several parameters as input data. Some examples are shown in FIG. 8 as blocks 551 - 559. Generally speaking, while more parameters can provide a more accurate kinematic model, all of blocks 551- 559 are not required to achieve a functional kinematic model. In fact, since the kinematic model 205 can be tailored for a particular array, entirely different parameters can be used in some implementations. For example, this example presumes that the solar cell array system uses geared elevation and axis motors and a jackscrew. Some solar cell array systems.can use direct drive and another means for adjusting the angle of the array. Therefore, the parameters are advantageously chosen based on the configuration of the particular array.

Some parameters are directed to the particular mechanical characteristics of the solar cell array system. The kinematic model 205, in this implementation, receives the pitch of the threaded rod (e.g., item 112 of FIG. 2). This parameter 551 is informative to the model 205 because depending on the thread pitch, more or less rotation will be required to accomplish a given linear translation (e.g., a finer thread pitch requires more rotation to accomplish the same linear translation than a coarser thread pitch). The gear ratios 552 are informative for the same reason-they are related to how much the motor driveshafts must rotate to accomplish a given amount of translation of the solar cell array 10. The jackscrew data 553 includes information about the jackscrew, such as length and position of the rod, and the angle between the solar cell array 10 and the threaded rod. This parameter 553 affects how much of the linear translation of the threaded rod 112 is translated into adjusting the angle of the solar cell array 10. For example, if the angle between the solar cell array 10 and the threaded rod is about ninety degrees, substantially all of the linear motion of the threaded rod is translated into adjusting the tilt of the solar cell array 10. Moreover, since the angle of the threaded rod can change as it translates, a trigonometric model can be used to continuously update this parameter (i.e., 553 can be a dynamic parameter). Azimuth and elevation motor home positions 555 are the positions that the controllers for azimuth and elevation motors, respectively, regard as their home positions. The elevation, home position can also be specified by the length of the threaded rod when the elevation motor is in its home position. Although such data may optionally also be included in the 553 data, the upper and lower arm distance parameter 557 is herein called out separately and relates to the distance between the top of the threaded rod (e.g., 112) of the jackscrew (e.g., 111) and the elevation hinge about which the solar cell array 10 rotates (e.g., hinge 104) and the distance between bottom of the threaded rod and the elevation hinge. This parameter 557 duplicates or is related to the jackscrew data parameters (553) in the sense that it also pertains to the geometry of the elevation adjustment and how translation of the threaded rod translates into changing the elevation angle. The zero jack angle parameter (558) is the elevation angle of the solar cell array (10) when the jackscrew angle is zero. The foregoing parameters can also affect the speed at which the motors are operated. For example, a finer thread pitch for the jackscrew (parameter 551) means that the elevation motor must rotate faster to accomplish a given change in elevation in a given time period as compared to a coarser thread pitch. As another example, a similar concept applies to the motor gear ratios (parameter 552).

Some parameters are directed to compensating for imperfections in the solar cell array installation and construction. For example, parameter 554 is directed to the base (e.g., item 101 of FIG. 1A) pitch and roll. The base might not be perfectly level, and therefore, as the solar panel translates in one direction, an errant translation also can occur in a second direction. Parameter 554 allows the kinematic model 205 to account for such errors. Also, in theory, the elevation axis (e.g., about hinge 104) is perpendicular to the azimuth axis (e.g., axis 103). However, variances in construction and/or assembly may result in the elevation and azimuth axes being non-perpendicular. Parameter 556 allows the model 205 to account for such an error. Also, in theory, the plane of the solar panel is perpendicular to the elevation hinge (e.g., hinge 104). Variances in construction and/or assembly may result in that not being the case. Parameter 559 allows the model 205 to account for such an error.

The kinematic model 205 receives parameters 551 - 559 and the sun's position at the future time (204). With that input data, the kinematic model 205 determines how the motors should be actuated (560) to align the solar panel with the sun at the future time. The future time (204) data is further utilized to specify the motor positions (560).

The data of blocks 551-559 can be stored in one or more data stores (e.g., magnetic media, solid state media, or other suitable memory structure). The processing of, e.g., blocks 553 and 205 can be performed by, e.g., one or more microprocessors or special or general purpose computers.

### Periodic Alignment Adjustment

Even for systems that are properly tracking solar movement, misalignment errors can occur, e.g., from sudden events such as wind gusts or from slowly-varying events such as degrading mechanical performance. Therefore, alignment adjustment techniques may be employed which sample an output parameter from a solar cell array and analyze that measurement to determine whether the corresponding solar cell array is properly aligned or not with the sun during solar tracking. The output parameter may be the normal output parameter measured by the solar cell, for example, photo-current or power. The sampling may occur periodically, e.g., at automatic intervals, or may be triggered by automatic or manual triggering events. The techniques may be executed automatically each day, each week, each month, or seasonally, or otherwise.

The system may consider numerous factors when analyzing the measured output parameter data. Factors may determine when to initiate the alignment testing routine altogether. Other factors may determine whether to execute alignment adjustment of the solar cell array based on the measured output parameters. For example, a decisional model may be used that analyzes power measured by the solar cell array system and considers whether there has been a sudden drop in power that suggests an re-alignment is needed (such as a wind storm or ground shift) or a sudden drop that does not (such as a cloud moving between the sun and array). Other factors may include the average power measured over the day while solar tracking, historical data from previous, similar tracking periods (e.g., the day before, a similar day the year before, etc.). The decisional model may consider all relevant factors.

To analyze, the array may be swept across one or more paths to identify an aligned position of the solar cell array 10. In other examples, the array is moved from one or more positions to one or more other positions to identify an aligned position between them. The aligned position may be where the maximum output parameter measurement occurs, and thus considered an optimum position; although in other examples the aligned position may be a less than optimum position. The aligned position may be determined by comparing measured output parameter values that occur during sweep movement or positioning. In performing that comparison, in some examples, a decisional model considers whether the compared data will produce accurate alignment position data. For example, when there is a small cloud immediately in between the solar cell array 10 and the sun, the decisional model operating during sweep may determine than an increase in measured output parameter may not be due to the array being moved into a more correctly-aligned position relative to the sun, but simply that the array has been moved to point in a direction of the sky that results in more solar energy hitting the array directly and without passing through the attenuated energy passing directly through the clouds. In such an example, although the solar cell array system may measure a higher power while sweeping, the initial position, blocked by the clouds, may be the actual aligned position. The decision model may thus compare measured output parameter data against other measured data on an accumulated basis (e.g., comparison to a running average) or using other data analysis tools to assess whether data measured during a sweep of the solar cell array is useful in determining proper alignment or not.

In some examples, drive means such as motors and actuators are used to sweep the solar cell array about a neutral position across specific azimuth and elevation paths to identify the actual aligned array position. However, the techniques are not limited to arrays with particular motor/actuator configurations, nor are the techniques dependent upon sweeping about a neutral position. Systems capable of sweeping an array either across large sweep angles (>10%) or small sweep angles (<10%) are suitable. Furthermore the amount of sweep that the array is required to cover may be time dependent and seasonally dependent. The techniques will be configured such that a sweep angle used during the morning is different than the sweep angle used in the evening, although in both instances the sweep angle is looking for the same drop off in the output parameter as indicating that the solar cell array needs to be realigned. The alignment adjustments may position the solar cell array to increase the power output produced by the array. While in other examples, the alignment adjustments may position the solar cell array to align with the sun.

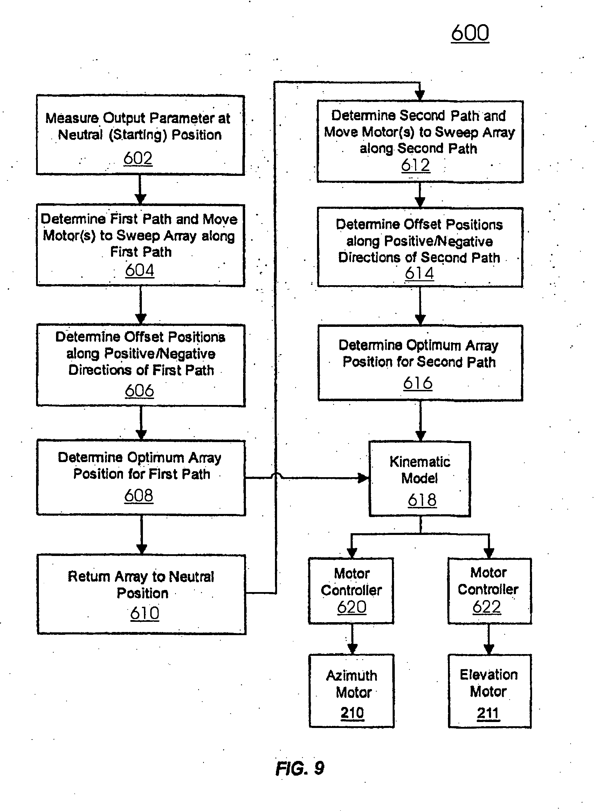

FIG. 9 illustrates an implementation 600 of a method for optimizing the position of a solar cell array, using a "find sun" routine as the alignment algorithm. The algorithm is termed a find sun routine, because it is designed to align the array by identifying an optimum point of the solar cell array relative to the sun. The alignment algorithms could identify a less than optimum position instead. The alignment algorithm can be executed manually by operator initiation or automatically, such as at predetermined intervals or at specifically determined events such as at start up. Other triggering events include a sudden decrease in a measured output parameter, which may indicate that the solar tracking routine is not aligned, or more slowly varying errors such as currently measured output parameters that are smaller in value than previous measurements from the same measurement period. For example, measured values can be compared to previous values within an identified time window, values measured in previous days, weeks, months, etc.

In addition to triggering based on sudden decreases, the routine 600 may be triggered by accumulated decreases over time, such as a continuous unexplained decrease in output power. Such decreases can occur due to defects in mechanical elements of the solar cell array, including gradual twisting and bending of mechanical support members or actuators. Such decreases can also result from shifting in the foundation or support of the solar cell array. The routine 600 may therefore be triggered by a decisional model that measures for such gradual changes over time. However, in many applications, these types of changes are so small that differential measured changes will have to be monitored over long periods of time and analyzed for example through regression or other modalities to assess when the routine should be executed. In some such examples, external sensors could be used to further trigger the alignment algorithm. These include pressure sensors in the support or foundation of a solar cell array, line of sight proximity switches used to identify misalignment, etc. The alignment may thus be continuous or done with a high enough periodicity.

Another small decrease in output parameter that accumulates over time is due to seasonal variations. Because the solar cell array must be angled differently during different seasons - the sun's position in the sky is higher in the summer than in the winter for example - the mechanical movement and responsiveness of the array can be different at different times of year. Changes in sun elevation can be the biggest culprit in producing seasonal-dependent bending or sagging in the mechanical elements of the solar cell array. For example, during the summer when the array is in a more horizontal, elevation position, the array may sag and bend more during movement, than when the panel is more vertical, as occurs in the winter. In any event, the alignment algorithms herein may be triggered based on such seasonal changes, either as a result of measured vales (output parameter, external sensors, etc.) as discussed above or as a result of triggering based on the time of year automatically programmed into a controller executing the routine.

The routine 600, which may be executed using a controller such as controller 212, measures, in step 602, an initial value of an output parameter for the solar cell array 10 at an initial position of the solar cell array, also termed a neutral position. If the routine 600 is executed during solar tracking, such as that described with reference to FIG. 2, then this neutral position may be a presumed optimum position relative to the sun, i.e., the solar cell array 10 is presumed to be orthogonal to the incoming rays of the sun, and the output parameter measurements are maximized. Due to misalignment, poor tracking, degrading equipment, etc., this presumed optimum position may in fact not be the optimum position. In other examples, the neutral position may be the position of the solar cell array 10 at start-up, before solar tracking has begun. In any event, the initial measurement of the output parameter is used as a baseline for assessing whether the current position of the solar cell panel is the optimum position.

To assess the optimum position, the routine 600 makes relatively small changes to the position of the solar cell array 10 along orthogonal directions and compares the resulting measurements for identifying a new optimum position. To that end, operation of the drive means is initiated, in step 604, to move the solar cell array 10 along a first path from the neutral position and first and second offset positions along that first path are determined in step 606, with these offset positions corresponding to positions of the solar cell array 10 at which the measured output parameter is at a predetermined level. The first path may be any path, preferably one of an azimuth or elevation path, while the second path is preferably the other of an azimuth or elevation path. The paths may be orthogonal, but need not be.

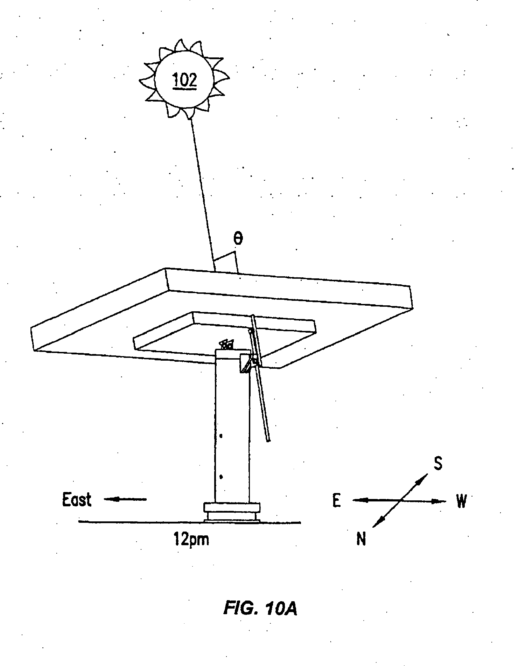

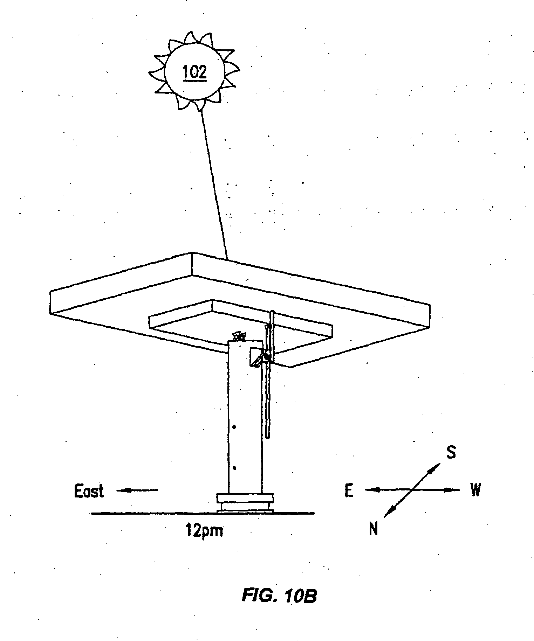

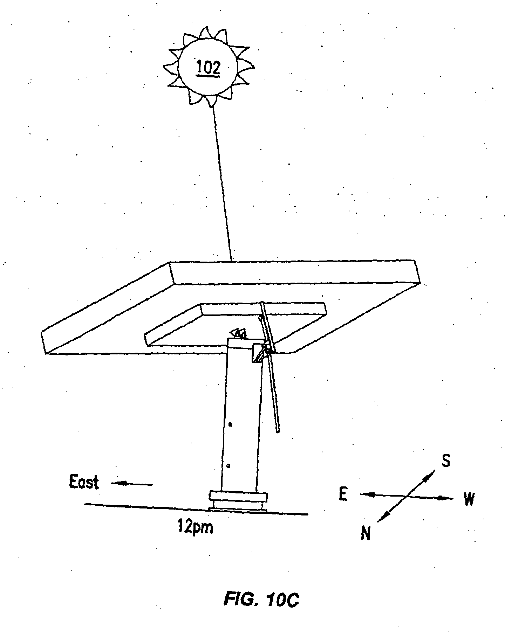

For example, to move the solar cell array 10 along an arcuate, azimuthal path, in step 604 the motor 210 (FIG. 2) is controlled to move the solar cell array 10 across an approximately 3 degree sweep from the neutral position. The use of 3 degrees is provided by way of example; the actual sweep could be larger or smaller and preferably depends on a predetermined amount of the output parameter (e.g., percentage drop off) measured at the neutral position or other presumed maximum position. Referring to FIGS. 10A-10C, for example, FIG. 10A illustrates the solar cell array 10 in a neutral position, FIG. 10B illustrates the solar cell array 10 after step 604 has moved the solar cell array 10 in a positive azimuthal direction relative to the neutral position, and FIG. 10C illustrates the solar cell array 10 after the step 604 has moved the solar cell array 10 in a negative azimuthal direction relative to the neutral position.

As step 604 moves the solar cell array 10, the output parameter is measured in step 606. The output parameter may be current or power measured by the solar cells of the solar cell array, or any other metric by which the accuracy of the solar cell array's position relative to the sun can be determined. The output parameter may be continuously or periodically measured in step 606. The measured output parameter is compared in step 606 to the initial output parameter, and the solar cell array motor(s) are controlled to stop when a predetermined value is determined. For example, with power as the output parameter, the solar cell array 10 may move until the measured power along the azimuthal power has dropped by 20% or more (e.g., by 25% of the initial measured output parameter) from that of the initial measured value (FIG. 10A). The position of the solar cell array at which point the power has dropped by this predetermined amount is determined to be an offset. A first offset occurs when the power has dropped by this amount in the positive direction; and a second offset occurs when the power has dropped by this amount in the negative direction.

Because the solar cell array 10 may not be at a position resulting in maximum power when the routine 600 is executed, it is likely that step 606 will measure an increase in the power while the solar cell array 10 is sweeping to either the positive direction (FIG. 10B) or the negative direction (FIG. 10C). A solar cell array having a neutral position that is in fact an optimum position will lose about 25% of its power when the array is offset from the sun by 1 degree. Therefore, considering that the array will likely not be at such an optimum position initially, generally the resulting sweep will be about 3 degrees.

The sweep time is controlled in step 604, and in one example was around 120 seconds. The sweeping during steps 604 and 606 used for the find sun routine typically occurs simultaneously with the normal solar tracking movement of the solar cell array 10. Therefore, the sweep time used should be balanced against that continual movement of the solar cell array 10.

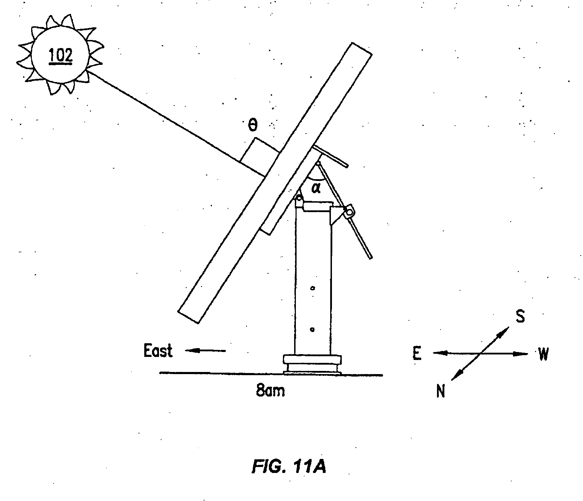

In step 608, the first offset position and the second offset position data from step 606 is compared and a better aligned azimuthal position for the solar cell array 10 is determined. For example, step 608 may average the first and second offset positions and identify an optimum position. This aligned (in this example optimum) position data is then stored, and in step 610 the array 10 is moved back to the neutral position (FIG. 11 A). This neutral position may be the static neutral position of FIG. 10A, i.e., when the azimuthal optimization occurred, or an elevational neutral position or a neutral position at a future point in time from that of FIG. 10A. In some examples, step 608 provides additional decisional model functions that determine whether or not to compare the first and second offset data in the first place, for example, by analyzing the measured output parameter data to assess whether the data indicates misalignment in fact or whether the data indicates another phenomena is at play, such a small cloud blocking the sun.

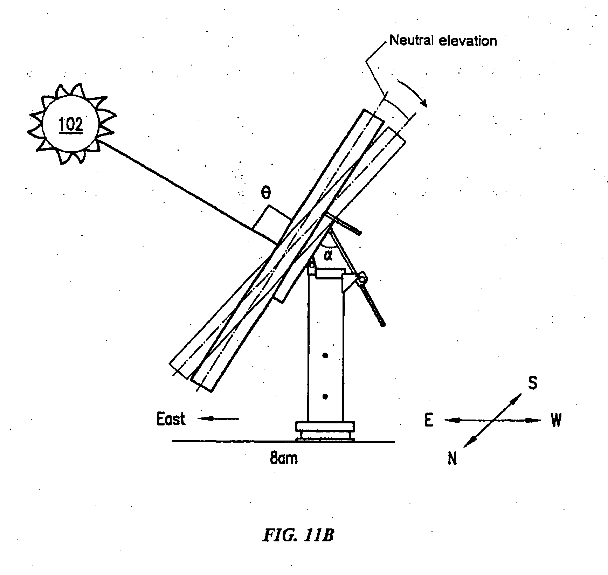

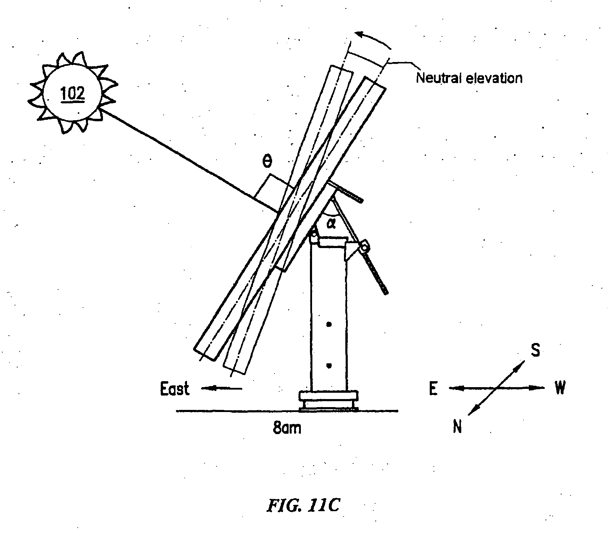

With the optimum position determined along one path, step 612 determines a second path, preferably orthogonal to the first path such as an elevation path. Step 612 actuates the motor(s) to move the solar cell array 10 from the neutral position of step 610 along this second path. That is, step 612 moves the array in a positive elevation direction (FIG. 11B) and a negative elevation direction (FIG. 11C) relative to the neutral position (FIG. 11A). Step 614, similar to step 606, determines the (now) third and fourth offset positions associated with predetermined changes in the measured output parameter along the elevation path. Step 616 then determines an optimum elevation position for the solar cell array 10, for example, by averaging the third and fourth offset positions.

The optimum position data derived in steps 608 and 616 is provided to a kinematic model 618, which, as part of the decisional model, determines the new azimuth motor position and the new elevation motor position for optimum positioning of the solar cell array 10 relative to the sun. The kinematic model 618 may be similar to those described above, in that the kinematic model may receive a number of input data from which motor control data is determined. Like with the solar tracking model of FIG. 3, the kinematic model 618 provides its motor control data to an azimuth motor controller 620 and an elevation motor controller 622, for controlling motors 210 and 211, respectively.

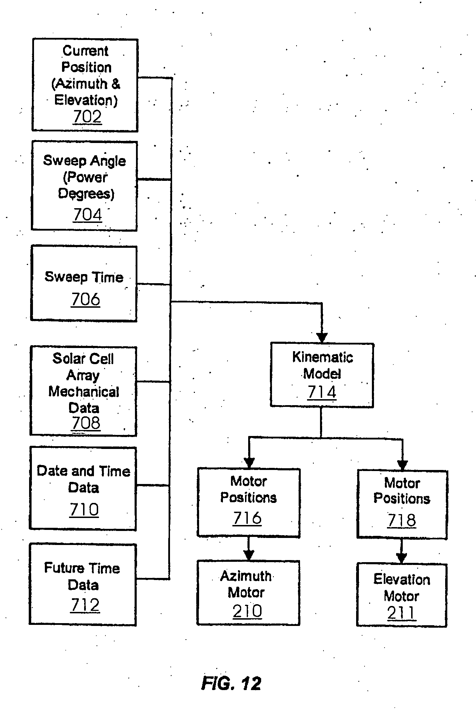

An exemplary structure for implementing step 604 is illustrated in FIG. 12, which is similar to that of FIG. 8. Step 604 sweeps the solar cell array 10 along an azimuthal path, by controlling actuation of one or both of the motors 210 and 211. In this example, only the motor 210 is needed to move the solar cell array in an azimuthal path under ordinary conditions. To perform this sweep, in step 604 several parameters are received as input data and supplied to a kinematic model. Some examples are shown in FIG. 12 as blocks 702-712. Generally speaking, while more parameters can provide a more accurate kinematic model, all of blocks 702-712 are not required to achieve a functional kinematic model. In fact, the parameters can be tailored for a particular array, and entirely different parameters can be used in some implementations. Each of the parameters is fed into a kinematic model 714, which produces motor position controls 716 and 718 for each of the azimuth and elevation motors 210 and 211, respectively.

Some parameters are directed to the particular mechanical characteristics of the solar cell array. A first parameter 702 describes the current azimuth and elevation position of the motors and thus of the solar cell array 10 itself. The desired sweep angle for an arcuate path is provided by step 704. This data may include the predetermined amount of drop off in output parameter that is to be used to determine the amount of sweep (e.g., 25% drop in power). This data may further include (or alternatively contain) the maximum sweep range in degrees (e.g., approximately 3 degrees in each positive and negative direction from a neutral position). The sweep time 706 is provided and sets the rate at which the array is swept. Date and time data 710 is provided and used by the kinematic model 714 to normalize the sweep angle data 704. This is useful for example as seasons change, where in the summer when the sun is high in the sky, the solar cell array 10 may need to move more than 3 degrees of Azimuth rotation to get 3 degrees of off-sun movement. Appropriate normalization and standardization of the control allows the kinematic model 714 to correlate the desired sweep angle with the requisite actuations to control the motors on the array 10. Future time data 712 reflecting the desired azimuth motor position at a future time and the desired elevation motor position at a future time are also provided to the kinematic model 714. Such data results from the solar tracking routine; such as that of FIG. 3, may be used to control motor actuation for the find sun routine while the solar cell array is also simultaneously tracking the sun.

The remaining data is generally categorized as mechanical data for the solar cell array 708 and generally includes data such as jackscrew pitch data, gear ratios for elevation and azimuth motors, jackscrew data such as length and position of the rod and angle between the rod and the solar cell array, the home positions for the azimuth and elevation motors, elevation rotation angle indicating variances in construction resulting in an elevation axis that is not fully perpendicular to the azimuth axis, bent array angle data indicating variances in construction resulting in the plane of the solar cell array not be perpendicular to the elevation hinge, a zero jack angle parameter indicating the elevation angle of the solar cell array when the jackscrew angle is zero, and azimuth and elevation motor home positions.

It will be understood that these parameters are provided for example purposes and are not meant to be complete or exhaustive or even required. Furthermore while the step 304 is described as using its own kinematic model 714, in other examples the step 304 may be implemented by the same system implementing the solar tracking of FIG. 2 thus using a single kinematic model able to control both solar tracking and separately control the off-sun movement for the find sun routine.
The data of blocks 702-712 can be stored in one or more data stores (e.g., magnetic media, solid state media, or other suitable memory structure). The processing of, e.g., block 714 can be performed by, e.g., one or more microprocessors or special or general purpose computers.

Embodiments of the subject matter and the functional operations described in this specification can be implemented in digital electronic circuitry, or in computer software, firmware, or hardware, including the structures disclosed in this specification and their structural equivalents, or in combinations of one or more of them. Embodiments of the subject matter described in this specification can be implemented as one or more computer program products, i.e., one or more modules of computer program instructions encoded on a computer readable medium for execution by, or to control the operation of, data processing apparatus. The computer readable medium can be a machine-readable storage device, a machine-readable storage substrate, a memory device, or a combination of one or more of them. The term "data processing apparatus" encompasses all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, a runtime environment or a combination of one or more of them. A propagated signal is an artificially generated signal, e.g., a machine-generated electrical, optical, or electromagnetic signal, that is generated to encode information for transmission to suitable receiver apparatus.

A computer program (also known as a program, software, software application, script, or code) can be written in any form of programming language, including compiled or interpreted languages, and it can be deployed in any form, including as a stand alone program or as a module, component, subroutine; or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed to be executed on one computer or on multiple computers that are located at one site or distributed across multiple sites and interconnected by a communication network.

The processes and logic flows described in this specification can be performed by one or more programmable processors executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer can be embedded in another device. Computer readable media suitable for storing computer program instructions and data include all forms of non volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

While operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous.

A number of implementations have been described. Nevertheless, it will be understood that various modifications may be made without departing from the spirit and scope of the invention. Accordingly, other embodiments are within the scope of the claims.

## Claims

1. An automated method of monitoring a photovoltaic solar cell array of a terrestrial solar cell system that tracks the sun, the system comprising two drive means each of which is operable to adjust a position of the array relative to a respective different axis, the method comprising:
(a) using a sun position predictor to predict a position of the sun during the course of the day, and using a kinematic model for the solar cell array to determine respective actuations for the two drive means corresponding to the solar cell array being substantially aligned with the sun during the course of the day; and
(b) sampling an output parameter of the solar cell array indicative of the performance of the solar cell array to determine a misalignment of the solar cell array.

2. The method of claim 1, further comprising in response to the sampling, adjusting the position of the solar cell array to increase power output produced by the solar cell array during the course of the day.

3. The method of claim 1, further comprising in response to the sampling, adjusting the position of the solar cell array to more accurately align the solar cell array with the sun during the course of the day.

4. The method of claim 1, wherein sampling the output parameter comprises:
initiating operation of the two drive means to move the solar cell array from a first position as provided by the sun position predictor to a second position; and
comparing a power output of the solar cell array at the first position with a power output of the solar cell array at the second position.

5. The method of claim 1, wherein sampling the output parameter comprises initiating operation of the two drive means to move the solar cell array from a first position as provided by the sun position predictor to a second position at which a measured output parameter of the solar cell array at the second position has decreased by a predetermined percentage from a measured output parameter of the solar cell array at the first position, the method further comprising determining an aligned position for the solar cell array along a first path defined by the first position and the second position.

6. The method of claim 5, wherein sampling the output parameter comprises initiating operation of the two drive means to move the solar cell array from a third position as provided by the sun position predictor to a fourth position at which a measured output parameter of the solar cell array at the fourth position has decreased by a predetermined percentage from z a measured output parameter of the solar cell array at the third position, the method further comprising determining an aligned position for the solar cell array along a second path defined by the third position and fourth position, where the second path is different from the first path.

7. The method of claim 6, wherein the first path is one of an azimuth path and an elevation path and the second path is the other of the azimuth path and the elevation path.

8. The method of claim 1, further comprising:
using the two drive means to move the solar cell array along a first path; and
determining an aligned position for the solar cell array along the first path.

9. The method of claim 8, further comprising:
using the two drive means to move the solar cell array along a second path different than the first; and
determining an aligned position for the solar cell array along the second path.

10. The method of claim 9, wherein the first path and the second path are orthogonal.

11. The method of claim 1, wherein the two drive means comprises at least one of a linear actuator or a rotational motor.

12. The method of claim 1, further comprising sampling the output parameter at periodic intervals.

13. The method of claim 1, wherein the solar cell array is in a vertical support tower configuration where the two drive means are mounted on a support for moving the solar cell array in azimuth and elevation directions, respectively.

14. The method of claim 1, further comprising:
storing the solar cell array in a parked position during the night; and
at a predetermined time relative to sunrise, moving the solar cell array from the parked position to a start up position at which operation of the solar cell array starts.

15. The method of claim 14, further comprising moving the solar cell array from the parked position to the start up position via a wake-up position.
